# EUROPEAN PATENT APPLICATION

(11) **EP 4 550 304 A1**
(43) Date of publication of application: **07.05.2025**
(21) Application number: 24209622.0
(22) Date of filing: 29.10.2024
(51) Int. Cl.: G09G 3/3233, G09G 3/3266

(54) **DISPLAY DEVICE**

(30) Priority: 30.10.2023 JP 2023185594
(71) Applicant: Japan Display Inc., Tokyo 105-0003 (JP)
(72) Inventor: MORITA, Tetsuo, Tokyo, 105-0003 (JP); TABATAKE, Hiroshi, Tokyo, 105-0003 (JP)
(74) Representative: MERH-IP Matias Erny Reichl Hoffmann Patentanwälte PartG mbB

(57) **Abstract**

According to one embodiment, a display device (DSP) includes a base (10), a plurality of pixels (PX) arranged in a matrix along first and second directions (X, Y) intersecting each other in a display area (DA) on the base (10), control signal lines supplying a control signal (EM) to the plurality of pixels (PX), and power supply lines supplying an initialization voltage (Vini) to the plurality of pixels (PX). Each of the plurality of pixels (PX) includes a pixel circuit (100) including a plurality of transistors (Tr1, Tr2, Tr3, Tr4, Tr5, Tr6, and Tr7) and a light emitting element (20) driven by the pixel circuit (100). The plurality of transistors (Tr1, Tr2, Tr3, Tr4, Tr5, Tr6, and Tr7) in the pixel circuit (100) includes a first transistor (Tr6) provided between the power supply line and the light emitting element (20). The first transistor (Tr6) becomes an on state based on the control signal (EM). The control signal lines extend to be connected to the plurality of pixels (PX) arranged in the first direction (X) and are arranged in the second direction (Y). The power supply lines extend to be connected to the plurality of pixels (PX) arranged in the second direction (Y) and are arranged in the first direction (X).

## Description

### FIELD

Embodiments described herein relate generally to a display device.

### BACKGROUND

Recently, display devices equipped with organic light-emitting diodes (OLED), which are light emitting elements functioning as display elements, have been put into practical use.

In such a display device, the light emitting elements are driven by pixel circuits, but when a short circuit occurs between an anode and a cathode of the light emitting element the display quality may be degraded depending on a dark spot based on the short circuit.

### BRIEF DESCRIPTION OF THE DRAWINGS

FIG. 1 is a view showing a configuration example of a display device of an embodiment.
FIG. 2 is a view showing an example of layout of a plurality of subpixels included in a pixel.
FIG. 3 is a view showing another example of the layout of a plurality of subpixels included in a pixel.
FIG. 4 is a schematic cross-sectional view showing the display device along A-A line in FIG. 2.
FIG. 5 is a schematic enlarged cross-sectional view showing a partition.
FIG. 6 is a schematic cross-sectional view illustrating the light emitting element formed using the partition.
FIG. 7 is a schematic cross-sectional view illustrating the light emitting element formed using the partition.
FIG. 8 is a schematic cross-sectional view illustrating the light emitting element formed using the partition.
FIG. 9 is a view illustrating an example of a circuit configuration of a pixel circuit.
FIG. 10 is a view illustrating an example of an operation of a pixel circuit.
FIG. 11 is a view schematically showing various wires connected to a pixel circuit in a comparative example of the present embodiment.
FIG. 12 is a view illustrating a case where a short circuit occurs between an anode and a cathode of a light emitting element in the comparative example of the present embodiment.
FIG. 13 is a view showing an example of a horizontal streak that occurs in a display area in a comparative example of the present embodiment.
FIG. 14 is a view schematically showing various wires connected to a pixel circuit in the present embodiment.
FIG. 15 is a view showing an example of a layout of the pixel circuit in the embodiment.
FIG. 16 is a view illustrating a case where a short circuit occurs between an anode and a cathode of a light emitting element in the present embodiment.
FIG. 17 is a view illustrating the fluctuation in luminance of the light emitting element, which occurs in the present embodiment.
FIG. 18 is a view showing an example of a vertical streak that occurs in the display area in the present embodiment.

### DETAILED DESCRIPTION

In general, according to one embodiment, a display device includes a base, a plurality of pixels arranged in a matrix along first and second directions intersecting each other in a display area on the base, control signal lines supplying a control signal to the plurality of pixels, and power supply lines supplying an initialization voltage to the plurality of pixels. Each of the plurality of subpixels includes a pixel circuit including a plurality of transistors and a light emitting element driven by the pixel circuit. The plurality of transistors in the pixel circuit includes a first transistor provided between the power supply line and the light emitting element, the first transistor becoming an on state based on the control signal. The control signal lines extend to be connected to the plurality of pixels arranged in the first direction and are arranged in the second direction. The power supply lines extend to be connected to the plurality of pixels arranged in the second direction and are arranged in the first direction.

An embodiment will be described hereinafter with reference to the accompanying drawings.

The disclosure is merely an example, and proper changes within the spirit of the invention, which are easily conceivable by a person of ordinary skill in the art, are included in the scope of the invention as a matter of course. In addition, in some cases, in order to make the description clearer, the widths, thicknesses, shapes and the like, of the respective parts are schematically illustrated in the drawings, compared to the actual modes. However, the schematic illustration is merely an example, and adds no restriction to the interpretation of the invention. In addition, in the specification and drawings, structural elements which function in the same or a similar manner to those described in connection with preceding drawings are denoted by like reference numbers, detailed description thereof being omitted unless necessary.

In the figures, an X-axis, a Y-axis and a Z-axis orthogonal to each other are described to facilitate understanding as needed. A direction along the X-axis is referred to as a first direction X, a direction along the Y-axis is referred to as a second direction Y, and a direction along the Z-axis is referred to as a third direction Z. Viewing various elements parallel to the third direction Z is referred to as plan view.

The display device according to the present embodiment is an organic electroluminescent display device including organic light emitting diodes (OLED) as display elements (light emitting elements), and is mounted on televisions, personal computers, mobile terminals, mobile phones, and the like.

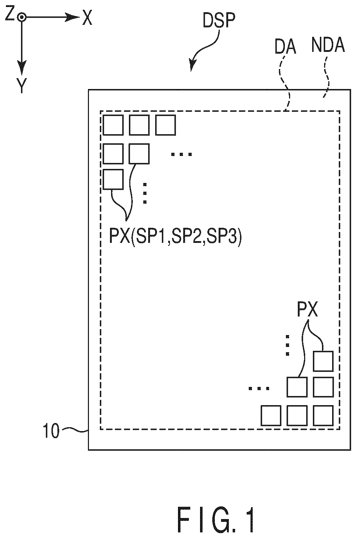

FIG. 1 is a view showing a configuration example of a display device DSP according to the present embodiment. The display device DSP has a display area DA where images are displayed and a non-display area NDA around the display area DA, on an insulating base 10. The base 10 may be glass or a flexible resin film.

In the present embodiment, the shape of the base 10 in plan view is a rectangular shape. However, the shape of the base 10 in plan view is not limited to a rectangular shape, but may also be the other shape such as a square, a circle or an ellipse.

The display area DA includes a plurality of pixels PX arrayed (arranged) in a matrix in the first direction X and the second direction Y that intersect each other. Each of the pixels PX includes a plurality of subpixels SP. In one example, the plurality of subpixels SP include red subpixels SP1, green subpixels SP2, and blue subpixels SP3. Incidentally, the plurality of subpixels SP may include subpixels of the other color such as white in addition to the subpixels SP1, SP2 and SP3. Incidentally, the plurality of subpixels SP may include subpixels of the other color instead of any subpixels of the subpixels SP1, SP2 and SP3.

Incidentally, as described in more detail below, each of the plurality of subpixels SP includes a pixel circuit and a light emitting element driven by the pixel circuit. The pixel circuit is composed of, for example, a plurality of transistors (switching elements composed of thin-film transistors), and the like. The light emitting element is the above-described organic light emitting diode. For example, the subpixel SP1 includes a light emitting element that emits light so as to emit light of a red wavelength range, the subpixel SP2 includes a light emitting element that emits light so as to emit light of a green wavelength range, and the subpixel SP3 includes a light emitting element that emits light so as to emit light of a blue wavelength range.

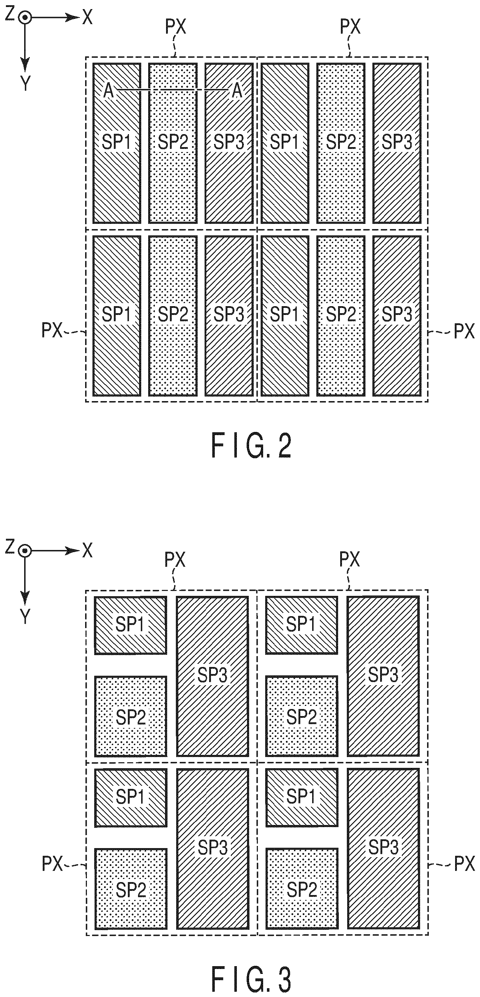

FIG. 2 shows an example of a layout of the plurality of subpixels SP (SP1, SP2, and SP3) included in the pixel PX. Four pixels PX are focused in this example.

Each of the subpixels SP1, SP2, and SP3 constituting one pixel PX are formed in a substantially rectangular shape extending in the second direction Y, and the subpixels are arranged in the first direction X. When two pixels PX arranged in the first direction X are focused, the colors displayed in the subpixels SP adjacent in the first direction X are different from each other. In addition, when two pixels PX arranged in the second direction Y are focused, the colors displayed in the subpixels SP adjacent in the second direction Y are the same. Incidentally, the area of the subpixels SP1, SP2, and SP3 may be the same or different from each other.

FIG. 3 shows another example of the layout of the plurality of subpixels (SP1, SP2, and SP3) included in the pixels PX.

The subpixels SP1 and SP2 constituting one pixel PX are arranged in the second direction Y, the subpixels SP1 and SP3 are arranged in the first direction X, and the subpixels SP2 and SP3 are arranged in the first direction X. The subpixel SP1 is formed in a substantially rectangular shape extending in the first direction X, and the subpixels SP2 and SP3 are formed in a substantially rectangular shape extending in the second direction Y. The area of the subpixel SP2 is larger than the area of the subpixel SP1, and the area of the subpixel SP3 is larger than the area of the subpixel SP2. Incidentally, the shape and area of the subpixel SP1 may be the same as those of the subpixel SP2.

When two pixels PX arranged in the first direction X are focused, the colors displayed in the subpixels SP adjacent in the first direction X are different from each other in the area where the subpixels SP1 and SP3 are provided alternately and the area where the subpixels SP2 and SP3 are provided alternately. In contrast, when two pixels PX arranged in the second direction Y are focused, the colors displayed in the subpixels SP adjacent in the second direction Y are different from each other in the area where the subpixels SP1 and SP2 are provided alternately. In addition, the colors displayed in the subpixels SP adjacent in the second direction Y are the same in the area where the plurality of subpixels SP3 are arranged.

Incidentally, the outer shape of the subpixels SP1, SP2 and SP3 shown in FIG. 2 and FIG. 3 correspond to the outer shape of the area (i.e., the light emitting area) where colors are displayed in the subpixels SP, but the shape is simplified and does not necessarily reflect the actual shape.

As described in more detail below, a rib and a partition are provided in the display area DA in the present embodiment. The rib includes an aperture in each of the subpixels SP1, SP2 and SP3. The partition is provided on a boundary between adjacent subpixels SP and overlaps with the rib in plan view. More specifically, the partition is provided between the apertures (subpixels SP) that are adjacent in the first direction X and between the apertures (subpixels SP) that are adjacent in the second direction Y. As a result, the partition has a grating shape formed to partition the subpixels SP1, SP2, and SP3 as a whole. In other words, the partition is considered to include apertures at the subpixels SP1, SP2, and SP3, similarly to the rib.

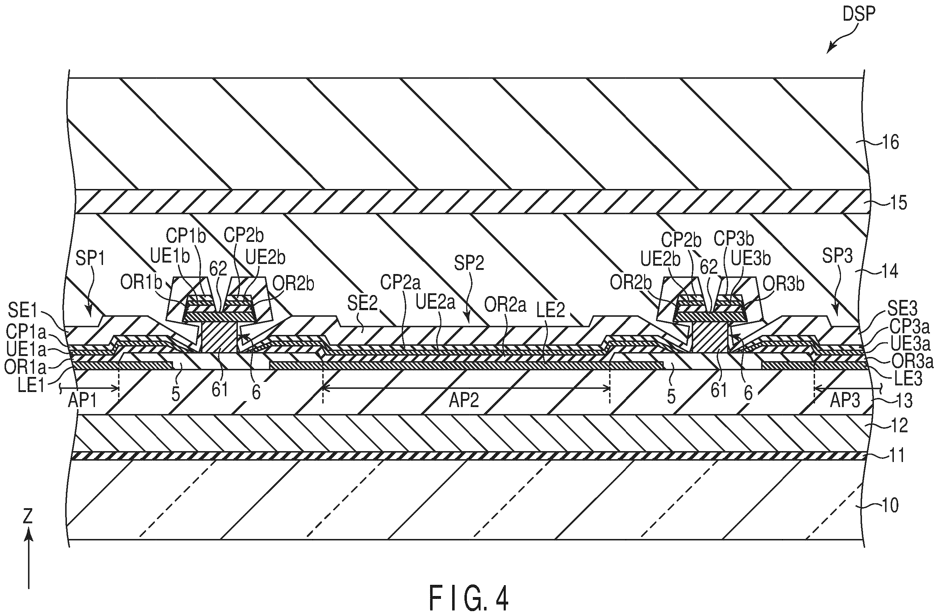

FIG. 4 is a schematic cross-sectional view showing the display device DSP along A-A line in FIG. 2. In the display device DSP, an insulating layer 11 referred to as an undercoat layer is provided on the above-described light-transmissive base 10 such as glass (i.e., on the surface of the side where the light emitting elements, and the like are provided).

The insulating layer 11 has, for example, a three-layer stacked structure with a silicon oxide film (SiO), a silicon nitride film (SiN), and a silicon oxide film (SiO). Incidentally, the insulating layer 11 is not limited to a three-layer stacked structure. The insulating layer 11 may have a stacked structure with more than three layers or may have a single-layer structure or a two-layer stacked structure.

A circuit layer 12 is provided on the insulating layer 11. The circuit layer 12 includes pixel circuits (various circuits and wires) that drives the light emitting elements included in each of the subpixels SP1, SP2, and SP3, as described above. The circuit layer 12 is covered with an insulating layer 13.

The insulating layer 13 functions as a planarization film which planarizes uneven parts generated by the circuit layer 12. Although not shown in FIG. 4, contact holes for connecting lower electrodes LE to the pixel circuit are provided in the insulating layer 13.

The lower electrodes LE (LE1, LE2, and LE3) are provided on the insulating layer 13. The rib 5 is provided on the insulating layer 13 and the lower electrodes LE. End portions (parts) of the lower electrodes LE are covered with the rib 5.

The partition 6 includes a lower portion 61 provided on the rib 5 and an upper portion 62 that covers an upper surface of the lower portion 61. The upper portion 62 has a width greater than that of the lower portion 61 in the first direction X and the second direction Y. As a result, the partition 6 has a shape in which both end portions of the upper portion 62 protrude beyond side surfaces of the lower portion 61. This shape of the partition 6 may be referred to as an overhang shape.

The organic layers OR (OR1, OR2 and OR3) and the upper electrodes UE (UE1, UE2 and UE3) constitute the light emitting elements included in the subpixels SP with the above-described lower electrodes LE (LE1, LE2 and LE3).

As shown in FIG. 4, the organic layer OR1 includes a first organic layer OR1a and a second organic layer OR1b that are separated from each other. The upper electrode UE1 includes a first upper electrode UE1a and a second upper electrode UE1b that are separated from each other. The first organic layer OR1a is in contact with the lower electrode LE1 through the aperture AP1 (i.e., an aperture of the rib 5 in the subpixel SP1) and covers a part of the rib 5. The second organic layer OR1b is located on the upper portion 62. The first upper electrode UE1a is opposed to the lower electrode LE1 and covers the first organic layer OR1a. Furthermore, the first upper electrode UE1a is in contact with side surfaces of the lower portion 61. The second upper electrode UE1b is located above the partition 6 and covers the second organic layer OR1b.

In addition, as shown in FIG. 4, the organic layer OR2 includes a first organic layer OR2a and a second organic layer OR2b that are separated from each other. The upper electrode UE2 includes a first upper electrode UE2a and a second upper electrode UE2b that are separated from each other. The first organic layer OR2a is in contact with the lower electrode LE2 through the aperture AP2 (i.e., an aperture of the rib 5 in the subpixel SP2) and covers a part of the rib 5. The second organic layer OR2b is located on the upper portion 62. The first upper electrode UE2a is opposed to the lower electrode LE2 and covers the first organic layer OR2a. Furthermore, the first upper electrode UE2a is in contact with side surfaces of the lower portion 61. The second upper electrode UE2b is located above the partition 6 and covers the second organic layer OR2b.

In addition, as shown in FIG. 4, the organic layer OR3 includes a first organic layer OR3a and a second organic layer OR3b that are separated from each other. The upper electrode UE3 includes a first upper electrode UE3a and a second upper electrode UE3b that are separated from each other. The first organic layer OR3a is in contact with the lower electrode LE3 through the aperture AP3 (i.e., an aperture of the rib 5 in the subpixel SP3) and covers a part of the rib 5. The second organic layer OR3b is located on the upper portion 62. The first upper electrode UE3a is opposed to the lower electrode LE3 and covers the first organic layer OR3a. Furthermore, the first upper electrode UE3a is in contact with the side surfaces of the lower portion 61. The second upper electrode UE3b is located above the partition 6 and covers the second organic layer OR3b.

In the example shown in FIG. 4, the subpixels SP1, SP2 and SP3 include cap layers CP1, CP2 and CP3 (optical path adjustment layers) for adjusting the optical property of the light emitted from light emitting layers of the organic layers OR1, OR2 and OR3.

The cap layer CP1 includes a first cap layer CP1a and a second cap layer CP1b that are separated from each other. The first cap layer CP1a is located in the aperture AP1 and is provided on the first upper electrode UE1a. The second cap layer CP1b is located above the partition 6 and is provided on the second upper electrode UE1b.

The cap layer CP2 includes a first cap layer CP2a and a second cap layer CP2b that are separated from each other. The first cap layer CP2a is located in the aperture AP2 and is provided on the first upper electrode UE2a. The second cap layer CP2b is located above the partition 6 and is provided on the second upper electrode UE2b.

The cap layer CP3 includes a first cap layer CP3a and a second cap layer CP3b that are separated from each other. The first cap layer CP3a is located in the aperture AP3 and is provided on the first upper electrode UE3a. The second cap layer CP3b is located above the partition 6 and is provided on the second upper electrode UE3b.

Sealing layers SE1, SE2 and SE3 are provided in the subpixels SP1, SP2 and SP3, respectively. The sealing layer SE1 continuously covers the members of the subpixel SP1 including the first cap layer CP1a, the partition 6, and the second cap layer CP1b. The sealing layer SE2 continuously covers the members of the subpixel SP2 including the first cap layer CP2a, the partition 6, and the second cap layer CP2b. The sealing layer SE3 continuously covers the members of the subpixel SP3 including the first cap layer CP3a, the partition 6, and the second cap layer CP3b.

In the example shown in FIG. 4, the second organic layer OR1b, the second upper electrode UE1b, the second cap layer CP1b, and the sealing layer SE1 on the partition 6 between the subpixels SP1 and SP2 are separated from the second organic layer OR2b, the second upper electrode UE2b, the second cap layer CP2b, and the sealing layer SE2 on the partition 6. In addition, the second organic layer OR2b, the second upper electrode UE2b, the second cap layer CP2b, and the sealing layer SE2 on the partition 6 between the subpixels SP2 and SP3 are separated from the second organic layer OR3b, the second upper electrode UE3b, the second cap layer CP3b, and the sealing layer SE3 on the partition 6.

The sealing layers SE1, SE2 and SE3 are covered with a resin layer 14 (planarization film). The resin layer 14 is covered with a sealing layer 15. Furthermore, the sealing layer 15 is covered with a resin layer 16.

The insulating layer 13 and the resin layers 14 and 16 are formed of organic materials. The rib 5, and the sealing layers 15 and SE (SE1, SE2, and SE3) are formed of, for example, an inorganic material such as silicon nitride (SiNx).

The lower portion 61 included in the partition 6 is conductive. The upper portion 62 included in the partition 6 may also be conductive. The lower electrode LE may be formed of a transparent conductive oxide such as indium tin oxide (ITO) or may have a stacked structure of a metal material such as silver (Ag) and a conductive oxide. The upper electrode UE may be formed of a conductive oxide such as ITO.

When the potential of the lower electrode LE is relatively higher than the potential of the upper electrode UE, the lower electrode LE corresponds to an anode (electrode) and the upper electrode UE corresponds to a cathode (electrode). In addition, when the potential of the upper electrode UE is relatively higher than the potential of the lower electrode LE, the upper electrode UE corresponds to an anode (electrode) and the lower electrode LE corresponds to a cathode (electrode).

The organic layer OR includes a pair of functional layers, and a light emitting layer provided between these functional layers. In an example, the organic layer OR has a structure in which a hole-injection layer, a hole-transport layer, an electron blocking layer, a light emitting layer, a hole blocking layer, an electron-transport layer, and an electron-injection layer are stacked in this order.

The cap layers CP (CP1, CP2, and CP3) are formed of, for example, a multilayer body of a plurality of transparent thin films. The multilayer body may include a thin film formed of an inorganic material and a thin film formed of an organic material as the plurality of thin films. In addition, these thin films have refractive indices different from each other. The materials of the thin films constituting the multilayer body are different from the materials of the upper electrode UE and are also different from the materials of the sealing layer SE. Incidentally, the cap layers CP may be omitted.

A common voltage is supplied to the partition 6. This common voltage is supplied to each of the upper electrodes UE (first upper electrodes UE1a, UE2a, and UE3a) that are in contact with the side surfaces of the lower portion 61. A pixel voltage is supplied to the lower electrodes LE (LE1, LE2, and LE3) through the pixel circuits included in the respective subpixels SP (SP1, SP2, and SP3).

When a potential difference is formed between the lower electrode LE1 and the upper electrode UE1, the light emitting layer of the first organic layer OR1a emits light in the red wavelength range. When a potential difference is formed between the lower electrode LE2 and the upper electrode UE2, the light emitting layer of the first organic layer OR2a emits light in the green wavelength range. When a potential difference is formed between the lower electrode LE3 and the upper electrode UE3, the light emitting layer of the first organic layer OR3a emits light in the blue wavelength range.

As another example, the light emitting layers of the organic layers OR1, OR2, and OR3 may emit light exhibiting the same color (for example, white). In this case, the display device DSP may include color filters that convert the light emitted from the light emitting layers into light exhibiting colors corresponding to the subpixels SP1, SP2, and SP3. In addition, the display device DSP may include a layer including quantum dots that are excited by the light emitted from the light emitting layers to generate the light of the colors corresponding to the subpixels SP1, SP2, and SP3.

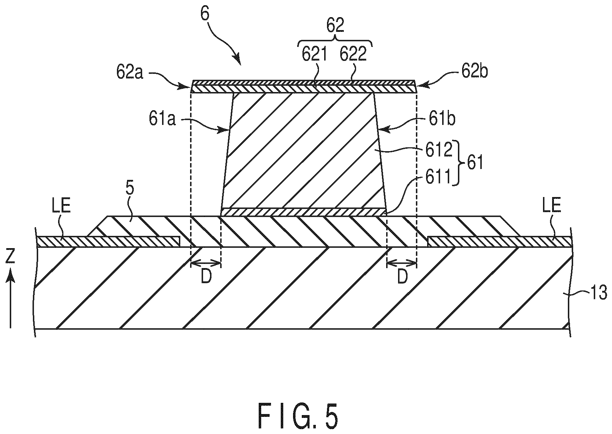

FIG. 5 is a schematic enlarged cross-sectional view of the partition 6. In FIG. 5, the elements other than the rib 5, the partition 6, the insulating layer 13 and a pair of lower electrodes LE are omitted. Each of the pair of lower electrodes LE corresponds to one of the above-described lower electrodes LE1, LE2 and LE3.

In the example shown in FIG. 5, the lower portion 61 of the partition 6 includes a barrier layer (bottom portion) 611 provided on the rib 5, and a metal layer (stem portion) 612 provided on the barrier layer 611. The barrier layer 611 is formed of a material that is different from the material of the metal layer 612, and is formed of, for example, a metal material such as molybdenum (Mo), titanium (Ti), and titanium nitride (TiN). The metal layer 612 is formed to be thicker than the barrier layer 611. The metal layer 612 may have a single-layer structure or a multilayer structure of different metal materials. In one example, the metal layer 612 is formed of, for example, aluminum (Al).

The upper portion (top portion) 62 is thinner than the lower portion 61. In the example shown in FIG. 5, the upper portion 62 includes a first layer 621 provided on the metal layer 612, and a second layer 622 provided on the first layer 621. In one example, the first layer 621 is formed of, for example, titanium (Ti) and the second layer 622 is formed of, for example, ITO.

In the example shown in FIG. 5, the width of the lower portion 61 decreases toward the upper portion 62. In other words, the side surfaces 61a and 61b of the lower portion 61 are inclined with respect to the third direction Z. Incidentally, the upper portion 62 includes an end portion 62a protruding from the side surface 61a and an end portion 62b protruding from the side surface 61b.

The amount D of protrusion of each of the end portions 62a and 62b from the side surfaces 61a and 61b (hereinafter, referred to as the amount of protrusion D of the partition 6) is, for example, less than or equal to 2.0 µm. In the embodiment, the amount of protrusion D of the partition 6 corresponds to the distance of the partition 6 between the lower ends of the side surfaces 61a and 61b (barrier layer 611) and the end portions 62a and 62b in a width direction (first direction X or second direction Y) orthogonal to the third direction Z.

In the example shown in FIG. 5, the side surface of the barrier layer 611 is aligned with the side surface of the metal layer 612, forming a flat surface with no steps but, for example, the side surface of the barrier layer 611 may be slightly recessed with respect to the side surface of the metal layer 612 or may protrude with respect to the side surface of the metal layer 612. In addition, in FIG. 5, the side surfaces of the barrier layer 611 and the metal layer 612 (i.e., the side surfaces 61a and 61b of the lower portion 61) are inclined with respect to the third direction Z, but these sides may also be parallel to the third direction Z.

The structure of the partition 6 and the materials of the portions of the partition 6 can be appropriately selected in consideration of, for example, the method for forming the partition 6, and the like.

In the present embodiment, the partition 6 is formed to divide the subpixels SP in plan view. The above-described organic layers OR are formed by, for example, a vacuum deposition method having anisotropy or directionality. When the organic material for forming each organic layer OR is deposited on the entire base 10 in a state in which the partition 6 is provided, the organic layers OR are not substantially formed on the side surfaces of the partition 6 since the partition 6 has the shape shown in FIG. 4 and FIG. 5. According to this, the organic layer OR (light emitting element) which is divided for each subpixel SP by the partition 6 can be formed.

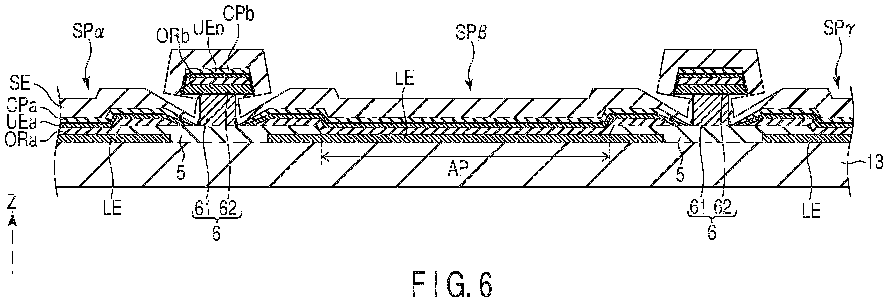

FIG. 6 to FIG. 8 are schematic cross-sectional views illustrating the light emitting elements formed using the partition 6. Incidentally, in FIG. 6 to FIG. 8, the base 10, the insulating layer 11, and the circuit layer 12 are omitted. In addition, each of subpixels SPα, SPβ, and SPγ shown in FIG. 6 to FIG. 8 corresponds to one of the subpixels SP1, SP2 and SP3.

First, the organic layer OR, the upper electrode UE, the cap layer CP and the sealing layer SE are formed in order over the entire base 10 by vapor deposition as shown in FIG. 6, in a state in which the partition 6 is provided as described above. The organic layer OR includes a light emitting layer which emits light exhibiting a color corresponding to the subpixel SPα. The partition 6 having an overhang shape divides the organic layer OR into a first organic layer ORa which is in contact with the lower electrode LE through the aperture AP and a second organic layer ORb on the partition 6, divides the upper electrode UE into a first upper electrode UEa which covers the first organic layer ORa and a second upper electrode UEb which covers the second organic layer ORb, and divides the cap layer CP into a first cap layer CPa which covers the first upper electrode UEa and a second cap layer CPb which covers the second upper electrode UEb. The first upper electrode UEa is in contact with the lower portion 61 of the partition 6. The sealing layer SE continuously covers the first cap layer CPa, the partition 6, and the second cap layer CPb.

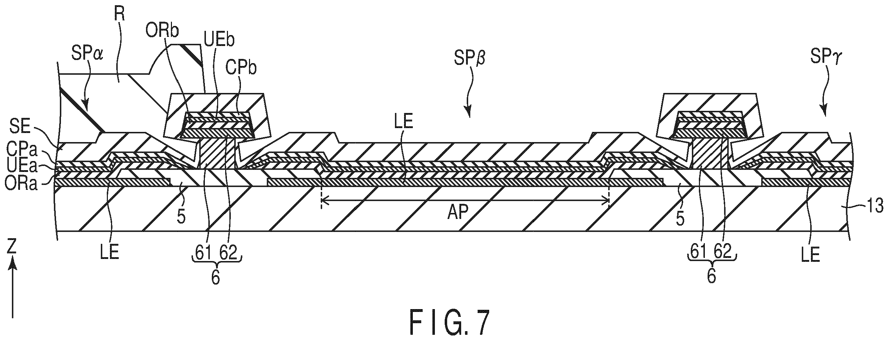

Next, a resist R is formed on the sealing layer SE as shown in FIG. 7. The resist R covers the subpixel SPα. In other words, the resist R is provided directly above the first organic layer ORa, the first upper electrode UEa, and the first cap layer CPa that are located in subpixel SPα. The resist R is also located directly above portions close to the subpixel SPα, of the second organic layer ORb, the second upper electrode UEb, and the second cap layer CPb on the partition 6 between the subpixel SPα and the subpixel SPβ. In other words, at least a part of the partition 6 is exposed from the resist R.

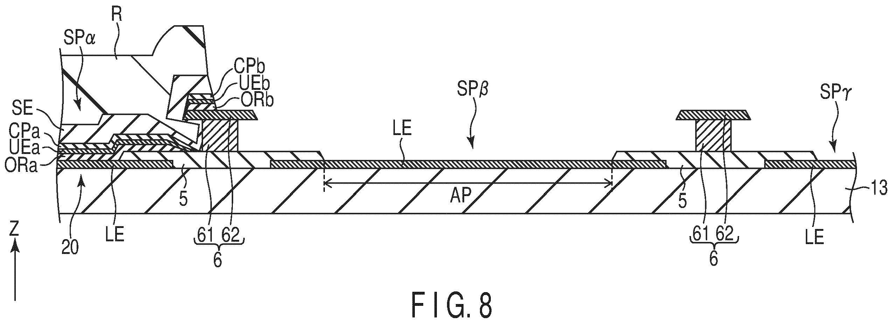

Furthermore, the portion exposed from the resist R is removed from the organic layer OR, the upper electrode UE, the cap layer CP and the sealing layer SE as shown in FIG. 8 by etching using the resist R as a mask. The light emitting element including the lower electrode LE, the first organic layer ORa, the first upper electrode UEa, and the first cap layer CPa is thereby formed in the subpixel SPα. In contrast, the lower electrode LE is exposed in the subpixels SPβ and SPγ. Incidentally, the above-described etching includes, for example, dry etching of the sealing layer SE, wet etching and dry etching of the cap layer CP, wet etching of the upper electrode UE, and dry etching of the organic layer OR.

When the light emitting element of the subpixel SPα is formed as described above, the resist R is removed, and the light emitting elements of the subpixels SPβ and SPγ are formed in series in the same manner as that of the subpixel SPα.

The structure of the display device DSP shown in FIG. 4 is realized by forming the light emitting elements of the subpixels SP1, SP2, and SP3 as exemplified above in relation to the subpixels SPα, SPβ, and SPγ and further forming the resin layer 14, the sealing layer 15, and the resin layer 16.

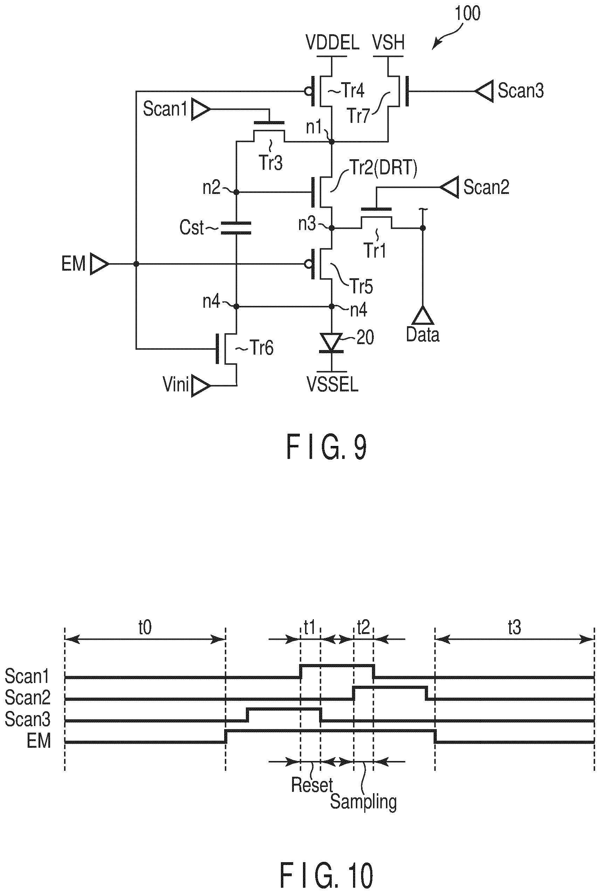

As described above, each of the plurality of subpixels SP includes the pixel circuit that drives the light emitting element. An example of the circuit configuration of the pixel circuit will be described below with reference to FIG. 9. Incidentally, a pixel circuit 100 shown in FIG. 9 is a 7Tr1C pixel circuit composed of seven transistors Tr1 to Tr7 and one storage capacitor Cst.

In the following descriptions, one of source/drain terminals of each of the transistors Tr1 to Tr7 shown in FIG. 9 is referred to as a first terminal while the other is referred to as a second terminal. In addition, one of terminals of (a capacitive element realizing) the storage capacitor Cst shown in FIG. 9 is referred to as a first terminal while the other terminal is referred to as a second terminal.

The first terminal of the transistor Tr1 is connected to the first terminal of the transistor Tr2 and the second terminal of the transistor Tr5 via a node n3. The second terminal of the transistor Tr1 is connected to a data signal line that supplies a data signal Data. The data signal Data corresponds to a signal (pixel signal) written to the pixel. Incidentally, the transistor Tr1 is, for example, an n-channel transistor.

The transistor Tr2 corresponds to a drive transistor (DRT) that supplies a current to the light emitting element 20 included in the subpixel SP (i.e., the light emitting element 20 driven by the pixel circuit 100). The first terminal of the transistor Tr2 is connected to the first terminal of the transistor Tr1 and the second terminal of the transistor Tr5 via a node n3. The second terminal of the transistor Tr2 is connected to the second terminal of the transistor Tr3, the first terminal of the transistor Tr4, and the first terminal of the transistor Tr7 via the node n1. Incidentally, the transistor Tr2 is, for example, an n-channel transistor.

The first terminal of the transistor Tr3 is connected to the gate terminal of the transistor Tr2 and the second terminal of the storage capacitor Cst via a node n2. The second terminal of the transistor Tr3 is connected to the second terminal of the transistor Tr2, the first terminal of the transistor Tr4, and the first terminal of the transistor Tr7 via the node n1. Incidentally, the transistor Tr3 is, for example, an n-channel transistor.

The first terminal of the transistor Tr4 is connected to the second terminal of the transistor Tr2, the second terminal of the transistor Tr3, and the first terminal of the transistor Tr7 via the node n1. The second terminal of the transistor Tr4 is connected to a power supply line that supplies a power supply voltage VDDEL. Incidentally, the transistor Tr4 is, for example, a p-channel transistor.

The first terminal of the transistor Tr5 is connected to the first terminal of the transistor Tr6, the first terminal of the storage capacitor Cst, and the anode terminal of the light emitting element 20 via a node n4. The second terminal of the transistor Tr5 is connected to the first terminal of the transistor Tr1 and the first terminal of the transistor Tr2 via a node n3. Incidentally, the transistor Tr5 is, for example, a p-channel transistor.

The first terminal of the transistor Tr6 is connected to the first terminal of the transistor Tr5, the first terminal of the storage capacitor Cst, and the anode terminal of the light emitting element 20 via a node n4. The second terminal of the transistor Tr6 is connected to the power supply line that supplies an initialization voltage Vini. Incidentally, the transistor Tr6 is, for example, an n-channel transistor.

The first terminal of the transistor Tr7 is connected to the second terminal of the transistor Tr2, the second terminal of the transistor Tr3, and the first terminal of the transistor Tr4 via the node n1. The second terminal of the transistor Tr7 is connected to the power supply line that supplies a power supply voltage VSH. Incidentally, the transistor Tr7 is, for example, an n-channel transistor.

In addition, as shown in FIG. 9, the gate terminal of the transistor Tr1 is connected to the gate signal line that supplies a gate signal Scan2. The gate terminal of the transistor Tr3 is connected to the gate signal line that supplies a gate signal Scan1. The gate terminals of the transistors Tr4 to Tr6 are connected to the control signal line that supplies a control signal EM. The gate terminal of the transistor Tr7 is connected to the gate signal line that supplies a gate signal Scan3.

The first terminal of the storage capacitor Cst is connected to the first terminal of the transistor Tr5, the first terminal of the transistor Tr6, and the anode terminal of the light emitting element 20 via the node n4. The second terminal of the storage capacitor Cst is connected to the gate terminal of the transistor Tr2 and the first terminal of the transistor Tr3 via the node n2.

The anode terminal of the light emitting element 20 is connected to the first terminal of the transistor Tr5, the first terminal of the transistor Tr6, and the first terminal of the storage capacitor Cst via the node n4. The cathode terminal of the light emitting element 20 is connected to the power supply line that supplies a power supply voltage VSSEL. The above-mentioned power supply voltage VDDEL corresponds to the anode voltage supplied to the light emitting element 20, and the power supply voltage VSSEL corresponds to the cathode voltage supplied to the light emitting element 20.

An example of the operation of the pixel circuit 100 (7Tr1C pixel circuit) shown in FIG. 9 described above will be simply described below with reference to FIG. 10. FIG. 10 is a timing chart showing an example of output of the gate signals Scan1 to Scan3 and the control signal EM for (the subpixel SP including) the pixel circuit 100.

Incidentally, the plurality of transistors constituting the pixel circuit 100 include the n-channel transistors and p-channel transistors, and the n-channel transistor is a switching element which is turned off (non-conductive) when a low (level) signal is supplied to the gate terminal and which is turned on (conductive) when a high (level) signal is supplied to the gate terminal. In contrast, the p-channel transistor is a switching element which is turned off (non-conductive) when a high (level) signal is supplied to the gate terminal and which is turned on (conductive) when a low (level) signal is supplied to the gate terminal.

In the period t0 shown in FIG. 10, the fourth transistors Tr4 and Tr5 of seven transistors included in the pixel circuit 100 are in the on state, and the transistor Tr6 is in the off state since the control signal EM is low.

In addition, during the period t0, the transistors Tr1, Tr3, and Tr7 are in the off state since the gate signals Scan1 to Scan3 are low.

According to this, the current controlled by the gate voltage of the transistor Tr2 (i.e., the voltage supplied to the gate terminal of the transistor Tr2 based on the data signal Data of the previous frame) flows to the light emitting element 20 (OLED), and the state in which the light emitting element 20 emits light is maintained.

Incidentally, the control signal EM is switched from low to high at the timing when the period t0 ends.

Next, a period t1 shown in FIG. 10 corresponds to a reset period. In the period t1, the transistors Tr4 and Tr5 are in the off state, and the transistor Tr6 is in the on state since the control signal EM is high. In this case, the initialization voltage Vini is supplied to the node n4 via the transistor Tr6, but no current flows to the light emitting element 20 during the period t1 since the initialization voltage Vini is set to a value at which no current flows to the light emitting element 20.

In addition, the gate signal Scan1 is switched from low to high at the timing when the period t1 starts. For this reason, the transistor Tr3 becomes the on state during the period t1. Furthermore, the gate signal Scan3 is switched from low to high after the period t0 ends and before the period t1 starts. For this reason, the transistor Tr7 is in the on state during the period t1. According to this, the power supply voltage VSH is supplied to the gate terminal of the transistor Tr2 via the transistors Tr7 and Tr3. In this case, a voltage VSH-Vini is applied to (an interval between first and second terminals between) the storage capacitor Cst, and the information of the previous frame is reset.

Incidentally, the gate signal Scan3 is switched from high to low at the timing when the period t1 ends.

Next, a period t2 shown in FIG. 10 corresponds to a sampling period. The gate signal Scan2 is switched from low to high at the timing when the period t2 ends. For this reason, the transistor Tr1 becomes the on state during the period t2. In addition, during the period t2, the transistor Tr7 is in the off state since the gate signals Scan3 is low.

In this case, (the voltage Vdata corresponding to) the data signal Data and the threshold voltage Vth of the transistor Tr2 (i.e., the voltage corresponding to Vdata + Vth) are supplied to the gate terminal of the transistor Tr2 via the transistors Tr1 to Tr3. According to this, the voltage of Vdata + Vth - Vini is applied to the storage capacitor Cst, and the information regarding Vdath and Vth is written to the storage capacitor Cst (in other words, the voltage that controls the current supplied to the light emitting element 20 by the transistor Tr2 is held in the storage capacitor Cst).

Incidentally, the gate signal Scan1 is switched from high to low at the timing when the period t2 ends.

Next, a period t3 shown in FIG. 10 corresponds to a light emission period. During the period t3, the transistor Tr3 is in the off state since the gate signals Scan1 is low. In addition, the transistor Tr1 is in the off state since the gate signal Scan2 is switched from high to low before the period t3 starts. Furthermore, the control signal EM is switched from high to low at the timing when the period t3 starts. For this reason, the transistors Tr4 and Tr5 become the on state, and the transistor Tr6 becomes the off state.

If the first terminal of the transistor Tr2 is assumed to be the source terminal, a voltage Vgs between the gate terminal and source terminal (nodes n2 to n3) of the transistor Tr2 becomes the voltage of the storage capacity Cst (Vdata + Vth - Vini). In this case, the transistor Tr2 becomes the on state, and a current flows from the power line connected to the second terminal of the transistor Tr4 (i.e., the power line that supplies the power supply voltage VDDEL) to the node n4. In response to this, when rise in the potential at the node n4 starts and the potential exceeds the threshold value of the light emitting element 20 (OLED), a current starts flowing to the light emitting element 20 and the light emission from the light emitting element 20 is started. Finally, when the current loled flowing to the light emitting element 20 reaches the output current (output current in the saturation region of the transistor Tr2) Idrt supplied by the transistor Tr2, the rise in the potential at the node n4 stops and the light emitting element 20 enters a steady-state emission state.

If the voltage between the gate and source terminals of the transistor Tr2 Vgs = Vdata + Vth - Vini is substituted into the TFT saturation equation Idrt = 1/2Cox*µ*W/L* (Vgs-Vth)², we get Idrt (= loled) = 1/2Cox*µ*W/L* (Vdata-Vini)² can be obtained. Cox is a gate capacitance per unit area, µ is the carrier mobility, W is a channel width of the transistor Tr2, and L is a channel length of the transistor Tr2.

According to this, it can be understood that Idrts becomes a value that does not depend on the threshold voltage Vth of the transistor Tr2 (in other words, a current that does not depend on the threshold voltage Vth of the transistor Tr2 flows to the light emitting element 20), and that the variation in the threshold voltage Vth can eliminate an influence given to Idrts.

In other words, it can be said that the pixel circuit 100 (7Tr1C pixel circuit) shown in FIG. 9 includes a function (Vth correction function) of correcting the variation in the threshold voltage Vth of the transistor Tr2.

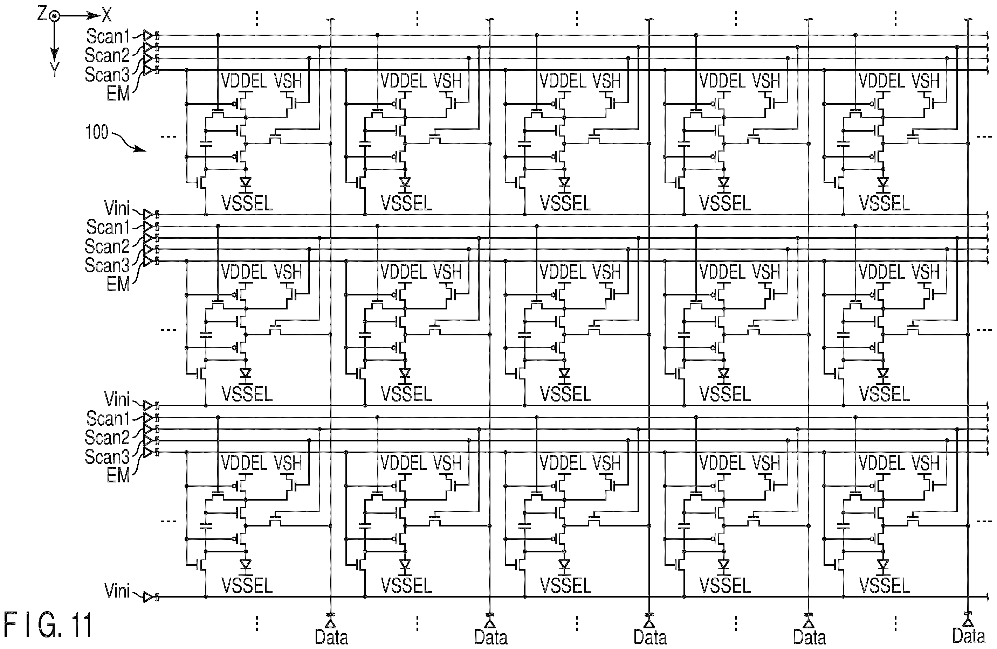

FIG. 11 schematically shows various wires connected to the pixel circuit 100 included in each of the plurality of subpixels SP provided in the display area DA of the display device DSP according to a comparative example of the present embodiment. FIG. 11 shows the gate signal lines that supply the gate signals Scan1 to Scan3, the control signal lines that supply the control signal EM, the power supply lines that supply the initialization voltage Vini, and the data signal lines that supply the data signal Data, among the plurality of wires connected to the pixel circuit 100.

In the comparative example of the present embodiment, as shown in FIG. 11, the gate signal lines that supply the gate signals Scan1 to Scan3, the control signal lines that supply the control signal EM, and the power supply lines that supply the initialization voltage Vini extend in the first direction X and are connected to the pixel circuit 100 included in each of the plurality of subpixels SP arranged in the first direction X. In addition, the gate signal lines that supply the gate signals Scan1 to Scan3, the control signal lines that supply the control signal EM, and the power supply lines that supply the initialization voltage Vini are arranged in the second direction Y in each of the rows constituted by the plurality of subpixels SP arranged in the first direction X in the display area DA.

In contrast, the data signal lines that supply the data signal Data extend in the second direction Y and are connected to the pixel circuit 100 included in each of the plurality of subpixels SP arranged in the second direction Y. In addition, the data signal lines that supply the data signal Data are arranged in the first direction X for each row of the sub-pixels SP arranged in the second direction Y in the display area DA.

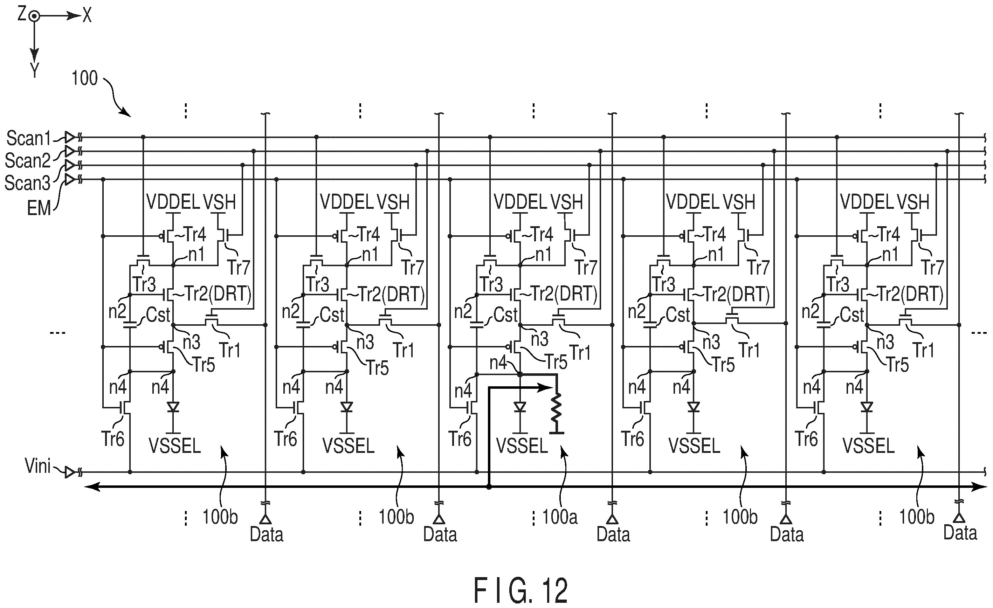

FIG. 12 shows the plurality of pixel circuits 100 included in the plurality of subpixels SP that constitute a row in the display area DA (i.e., the plurality of pixel circuits 100 connected to a single power supply line that supplies the initialization voltage Vini in the comparative example of the present embodiment). In FIG. 12, it is assumed that a short circuit (EL short between the anode electrode and the cathode electrode) has occurred between the anode and the cathode of the light emitting element 20 driven by a pixel circuit 100a among the plurality of pixel circuits 100.

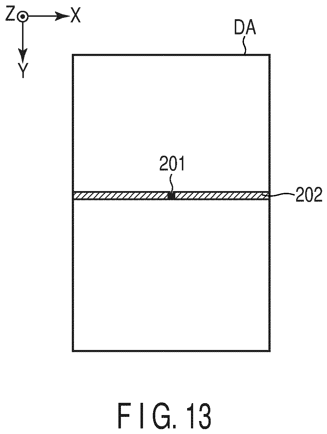

As described above, when a short circuit occurs between the anode and the cathode of the light emitting element 20, the light emitting element 20 cannot emit light, and, the subpixel SP including the light emitting element 20 is therefore visually recognized as a dark spot 201 in (the screen displayed in) the display area DA as shown in FIG. 13.

Incidentally, as described with reference to FIG. 10, in order to make the light emitting element 20 emit light in the pixel circuit 100, a voltage of Vdata + Vth - Vini needs to be applied to the storage capacitor Cst, and the transistor Tr6 becomes the on state in the pixel circuit 100.

In this case, the control signal line that supplies the control signal EM to turn on the transistors Tr6 extends in the first direction X, and the transistors Tr6 are turned on at the same timing in the pixel circuits 100 included in the plurality of subpixels SP constituting a single row (i.e., arranged in the first direction X).

In addition, in the comparative example of the present embodiment, the power supply line that supplies the initialization voltage Vini extends in the first direction X, and the initialization voltage Vini is supplied to the plurality of pixel circuits 100 included in the plurality of subpixels SP constituting a line. In this case, the initialization voltage Vini is supplied to the node n4 via the transistors Tr6 as described with reference to FIG. 9 but, since the initialization voltage Vini is set to a value at which no current flows to the light emitting elements 20, no current flows to the light emitting elements 20 and the pixel circuits 100 can operate properly.

However, if a short circuit occurs between the anode and the cathode of the light emitting element 20 driven by the pixel circuit 100a shown in FIG. 12 and if the transistor Tr6 is turned on in the pixel circuit 100a, a current flows from the power supply line supplying the initialization voltage Vini to the power supply line supplying the power supply voltage VSSEL and, as a result, a potential fluctuation occurs in the initialization voltage Vini supplied via the power supply line connected to the pixel circuit 100a.

Since the power line supplying the initialization voltage Vini is connected to each of the pixel circuits 100 included in the plurality of subpixels SP constituting a line, the initialization voltage Vini in which the potential fluctuation occurs as described above is also supplied to other pixel circuits 100b other than the pixel circuit 100a.

As described above, since the output current Idrt supplied from the transistor Tr2 in the pixel circuit 100 is expressed as 1/2Cox*µ*W/L* (Vdata - Vini)², the potential fluctuation that occurs in the initialization voltage Vini affects the output current Idrt. In other words, the luminance of the light emitting element 20 fluctuates in response to the potential fluctuation occurring in the initialization voltage Vini as described above, in the other subpixels SP arranged in the same row as the subpixel SP including the pixel circuit 100a (i.e., the subpixels SP including the pixel circuits 100b).

Incidentally, it can be said that such luminance fluctuation in the light emitting element 20 occurs in the subpixel SP where the period during which the potential fluctuation of the initialization voltage Vini occurs (i.e., the period during which the transistor Tr6 of the pixel circuit 100 driving the light emitting element 20 where a short has occurred is in the on state) overlaps with the above-described sampling period (i.e., the period during which the data signal Data is written).

According to this, in the comparative example of the present embodiment, as shown in FIG. 13, a streak 202 extending in the first direction X from the above-mentioned dark spot 201 on the display area DA can be visually recognized (i.e., a thin vertical streak occurs across one line), and the display quality of the display device DSP is degraded.

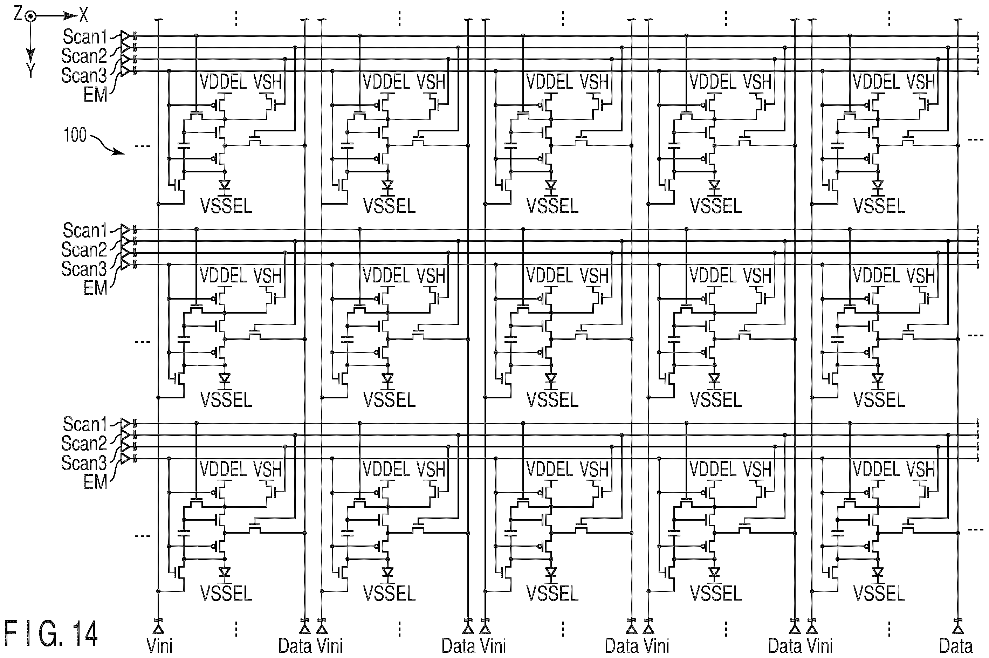

Thus, in the present embodiment, as shown in FIG. 14, the power supply line supplying the initialization voltage Vini is arranged to extend in not the first direction X, but the second direction Y. According to such a configuration, for example, even if a short circuit occurs between the anode and the cathode of the light emitting element 20 included in one subpixel SP, it is possible to avoid the occurrence of a thin horizontal streak on the display area DA as shown in FIG. 13 since the initialization voltage Vini in which a potential fluctuation occurs is not supplied to the plurality of pixel circuits 100 included in the plurality of subpixels SP constituting the same row as the subpixel SP.

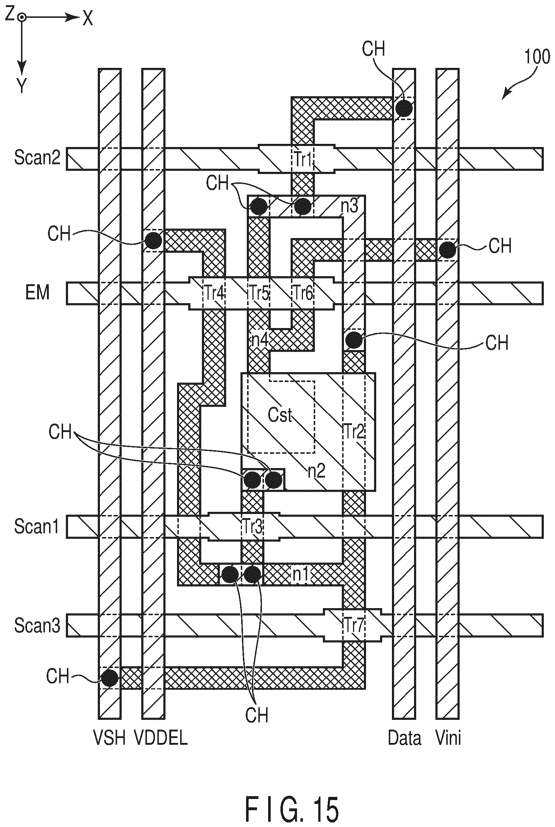

FIG. 15 is a view showing an example of a layout of the pixel circuit 100 in the embodiment. FIG. 15 shows, for example, various elements (transistors Tr1 to Tr7, storage capacitor Cst, gate signal line, control signal line, data signal line, and various power supply lines) of the pixel circuit 100 formed in the circuit layer 12 composed of first to third layers.

Incidentally, it is assumed that the first layer is the layer formed under the second layer and that the second layer is the layer formed under the third layer. In other words, it is assumed that the first to third layers are stacked in order with the first layer being the bottom layer and the third layer being the top layer.

The first layer is the layer in which the semiconductor layer is formed, and the second and third layers are the layers in which the electrodes constituting the transistor, the wires connected to the transistor, and the like are formed.

More specifically, the transistors Tr1 to Tr7 are formed across the first and second layers. In addition, similarly to the transistors Tr1 to Tr7, the storage capacitor Cst is formed across the first and second layers.

In addition, the gate signal line and the control signal line are formed on the second layer. Furthermore, the data signal line and various power supply lines are formed on the third layer.

The connections between various elements of the pixel circuit 100 described above have been described with reference to FIG. 9 and their detailed descriptions will be omitted here, but the elements formed in different layers as shown in FIG. 15 are connected via contact holes CH.

Incidentally, the layout of the pixel circuit 100 shown in FIG. 15 is an example, and parts of the layout of the pixel circuit 1000 may be different from the example shown in FIG. 15.

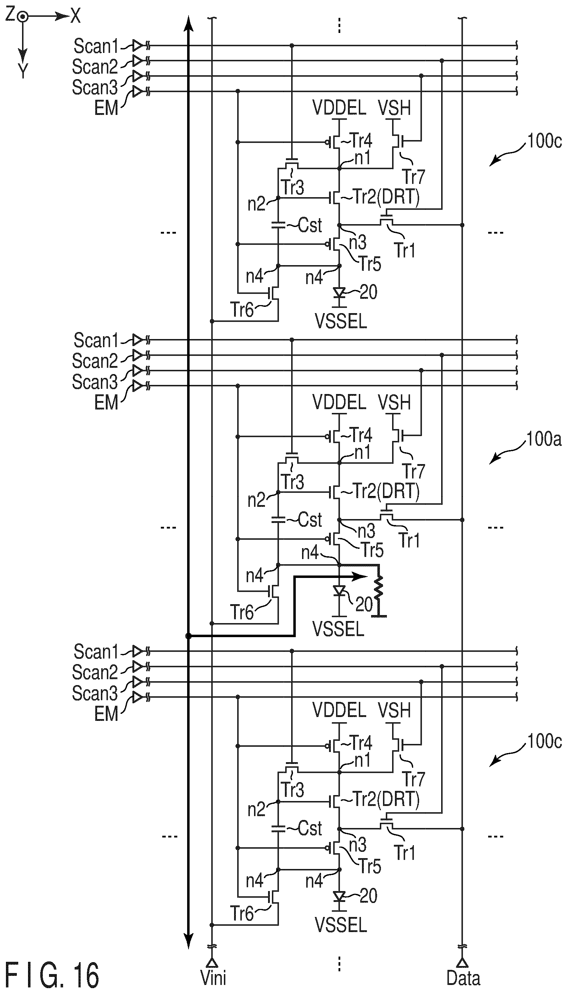

FIG. 16 shows a plurality of pixel circuits 100 included in the plurality of subpixels SP constituting a single row in the display area DA (i.e., a plurality of pixel circuits 100 connected to a single power supply line that supplies the initialization voltage Vini in the present embodiment). In FIG. 16, it is assumed that a short circuit has occurred between the anode and the cathode of the light emitting element 20 driven by a pixel circuit 100a among the plurality of pixel circuits 100.

In this case, in the present embodiment, the power supply line supplying the initialization voltage Vini extends in the second direction Y (i.e., the power supply line is connected to the plurality of pixel circuits 100 arranged in the second direction Y). For this reason, when the transistor Tr6 of the pixel circuit 100a shown in FIG. 16 is turned on, a potential fluctuation occurs in the initialization voltage Vini supplied via the power supply line connected to the pixel circuit 100a due to the short circuit which occurs between the anode and the cathode of the light emitting element 20 driven by the pixel circuit 100a.

Since the power supply line supplying the initialization voltage Vini is connected to each of the pixel circuits 100 included in the plurality of subpixels SP constituting a single row, the initialization voltage Vini in which the potential variation occurs as described above, is also supplied to other pixel circuits 100c other than the pixel circuit 100a.

As described above, since the output current Idrt supplied from the transistor Tr2 in the pixel circuit 100 is expressed as 1/2Cox*µ*W/L* (Vdata - Vini)², the potential fluctuation that occurs in the initialization voltage Vini affects the output current Idrt. In other words, the luminance of the light emitting element 20 fluctuates in response to the potential fluctuation occurring in the initialization voltage Vini as described above, in the plurality of subpixels SP arranged in the same column as the subpixel SP including the pixel circuit 100a (i.e., the subpixels SP including the pixel circuits 100c).

According to this, in the present embodiment, it is thought that a streak (a thin vertical streak) extending in the second direction Y from the dark spot occurs due to a short circuit occurring between the anode and the cathode of the light emitting element 20 on the display area DA.

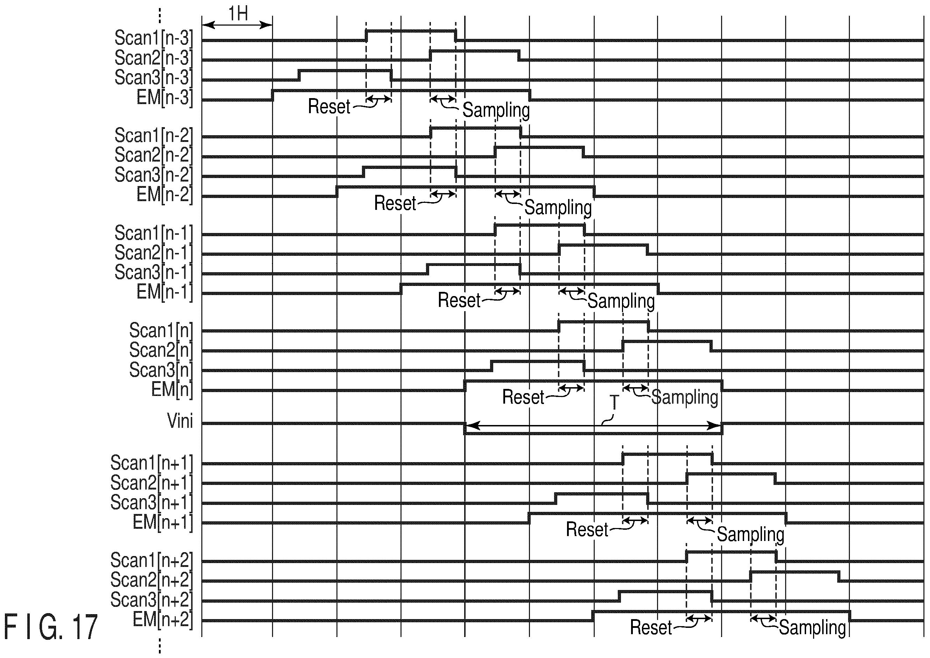

FIG. 17 shows an example of the output of the gate signals Scan1 to Scan3 and the control signal EM for each of the rows composed of the plurality of subpixels SP arranged in the display area DA.

It is shown in FIG. 17 that, for example, a potential fluctuation occurs in the initialization voltage Vini during the period (hereinafter referred to as a fluctuation period) T during which the transistor Tr6 of the pixel circuit 100 included in the subpixel SP becomes in the on state due to a short circuit occurring between the anode and the cathode of the light emitting element 20 included in one of the plurality of subpixels SP constituting n rows.

Incidentally, as described above, the luminance of the light emitting element 20 fluctuates due to the influence of the potential fluctuation in the initialization voltage Vini when the sampling period overlaps with the fluctuation period T. As shown in FIG. 17, the timing at which the gate signals Scan1 to Scan3 and the control signal EM are output is different for each row in the display area DA. In other words, since the timing at which the sampling period starts is different from the timing at which the sampling period ends, depending on the row in the display area DA, the luminance of the light emitting element 20 does not change in all the subpixels SP that are arranged in the same row as the subpixel SP including the light emitting element 20 where a short circuit occurs between the anode and the cathode (i.e., that are connected to the power supply line supplying the same initialization voltage Vini as the subpixel SP), in the present embodiment.

More specifically, for example, if it is assumed that the gate signals Scan1 to Scan3 and the control signal EM are output (supplied) according to a predetermined horizontal period (1H), in the example shown in FIG. 17, the period (i.e., fluctuation period) T during which a potential fluctuation occurs in the initialization voltage Vini by supplying the control signal EM to turn on the transistor Tr6 of the pixel circuit 100 included in the plurality of subpixels SP constituting n rows, is four horizontal periods (4H), and the fluctuation period T only overlaps with the sampling period in n-2, n-1, and n+1 lines.

In other words, according to the example shown in FIG. 17, for example, even if a short circuit occurs between the anode and the cathode of the light emitting element 20 included in one of the plurality of subpixels SP constituting n lines, the luminance of the light emitting element 20 included in the subpixels SP constituting each of n-2 line, n-1 line, and n+1 line, among the subpixels SP arranged in the same row as the sub-pixel SP in question SPs in the same row as the subpixel SP, fluctuates and the luminance does not fluctuate in the subpixels SP constituting the other line.

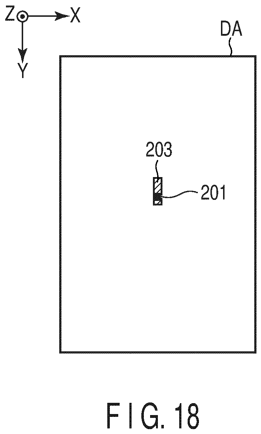

In this case, as shown in FIG. 18, only a short vertical streak 203 occurs in two subpixels SP located in the direction opposite to the second direction Y (i.e., in the upper direction) extending from a dark spot 201 and one subpixel SP located in the second direction Y (i.e., in the lower direction), in the display area DA.

As described above, the display device DSP of the present embodiment includes the base 10, a plurality of subpixels SP arranged in a matrix pattern along the first direction X and the second direction Y that intersect each other in the display area DA on the base 10, the control signal line that supplies the control signal EM to each of the plurality of subpixels SP, and the power supply line that supplies the initialization voltage Vini to each of the plurality of subpixels SP. Each of the plurality of subpixels SP includes a pixel circuit 100 composed of a plurality of transistors and a light emitting element 20 driven by the pixel circuit 100. The plurality of transistors constituting the pixel circuit 100 are provided between the power supply line that supplies the initialization voltage Vini and the light emitting elements 20, and include transistors Tr6 (first transistors) that become the on state based on the control signal EM. In addition, the control signal line that supplies the control signal EM extends to connect to the plurality of subpixels SP arranged in the first direction X, and is arranged in the second direction Y. The power supply line that supplies the initialization voltage Vini extends to connect to the plurality of sub-pixels SP arranged in the second direction Y, and is arranged in the first direction X.

Incidentally, the pixel circuit 100 is further composed of a storage capacity Cst in addition to the plurality of transistors, the plurality of transistors include the transistor Tr2 (second transistor) that supplies a current to the light emitting element 20, the storage capacity Cst is configured to hold the voltage that controls the current supplied to the light emitting element 20 by the transistor Tr2, and the transistor Tr6 is connected to the storage capacity Cst.

In addition, the plurality of transistors constituting the pixel circuit 100 are connected to the data signal line that supplies the data signal Data, and include the transistor Tr1 (third transistor) that becomes the on state based on the gate signal Scan2. The data signal line that supplies the data signal Data extends to be connected to the plurality of subpixels SP arranged in the second direction Y, and is arranged in the first direction X. The gate signal line that supplies the gate signal Scan2 extends to be connected to the plurality of subpixels SP arranged in the first direction X, and is arranged in the second direction Y.

In the present embodiment, according to the above-described configuration, a horizontal streak that occurs across a single row in the display area DA, as shown in, for example, FIG. 13 can be avoided, even if the transistors Tr6 of the plurality of pixel circuits 100 included in the plurality of subpixels SP become the on state to write the data signal Data to each row (constituted by) of the plurality of subpixels SP arranged in the first direction X. Furthermore, in the present embodiment, only a short vertical streak 203 as shown in FIG. 18 occurs on the display area DA, and such a vertical streak 203 is at a level of not being visually recognized. In other words, according to the present embodiment, compared to the configuration in which the power supply line that supplies the initialization voltage Vini is arranged to extend in the first direction X, similarly to the comparative example of the above-described embodiment, the degradation in the display quality of the display device DSP can be suppressed.

In the present embodiment, it has been described that the control signal line that supplies the control signal EM is arranged to extend in the first direction X and the power supply line that supplies the initialization voltage Vini is arranged to extend in the second direction Y. However, the control signal line and the power supply line may be provided in a direction of intersection and, for example, the control signal line may extend in the second direction Y and the power supply line may extend in the first direction X.

However, in order to efficiently drive the light emitting elements 20 included in the plurality of subpixels SP arranged in a matrix as described above, it is desirable to arrange the control signal line that supplies the control signal EM and the gate signal lines that supply the gate signals Scan1 to Scan 3 to extend in the same direction, and to arrange the power supply line that supplies the initialization voltage Vini and the data signal line that supplies the data signal Data to extend in the same direction.

All display devices, which are implementable with arbitrary changes in design by a person of ordinary skill in the art based on the display device described above as the embodiments of the present invention, belong to the scope of the present invention as long as they encompass the spirit of the present invention. Despite claims 3 and 4 are dependent on claims 2 and 3, respectively, in the appended claims, they can also be combined with any other preceding claim(s) or any other combination of preceding claims.

Various modifications are easily conceivable within the category of the idea of the present invention by a person of ordinary skill in the art, and these modifications are also considered to belong to the scope of the present invention. For example, additions, deletions or changes in design of the constituent elements or additions, omissions or changes in condition of the processes may be arbitrarily made to the above embodiments by a person of ordinary skill in the art, and these modifications also fall within the scope of the present invention as long as they encompass the spirit of the present invention.

In addition, the other advantages of the aspects described in the above embodiments, which are obvious from the descriptions of the specification or which are arbitrarily conceivable by a person of ordinary skill in the art, are considered to be achievable by the present invention as a matter of course.

## Claims

1. A display device (DSP), **characterized by** comprising:
a base (10);
a plurality of pixels (PX) arranged in a matrix along first and second directions (X, Y) intersecting each other in a display area (DA) on the base (10);
control signal lines supplying a control signal (EM) to the plurality of pixels (PX); and
power supply lines supplying an initialization voltage (Vini) to the plurality of pixels (PX), **characterized in that**
each of the plurality of pixels (PX) includes a pixel circuit (100) including a plurality of transistors (Tr1, Tr2, Tr3, Tr4, Tr5, Tr6, and Tr7) and a light emitting element (20) driven by the pixel circuit (100),
the plurality of transistors (Tr1, Tr2, Tr3, Tr4, Tr5, Tr6, and Tr7) in the pixel circuit (100) includes a first transistor (Tr6) provided between the power supply line and the light emitting element (20), the first transistor (Tr6) becoming an on state based on the control signal (EM),
the control signal lines extend to be connected to the plurality of pixels (PX) arranged in the first direction (X) and are arranged in the second direction (Y), and
the power supply lines extend to be connected to the plurality of pixels (PX) arranged in the second direction (Y) and are arranged in the first direction (X).

2. The display device (DSP) of claim 1, **characterized in that**
the pixel circuit (100) further includes a storage capacitor (Cst) in addition to the plurality of transistors (Tr1, Tr2, Tr3, Tr4, Tr5, Tr6, and Tr7),
the plurality of transistors (Tr1, Tr2, Tr3, Tr4, Tr5, Tr6, and Tr7) in the pixel circuit (100) include a second transistor (Tr2) configured to supply a current to the light emitting element (20),
the storage capacitor (Cst) in the pixel circuit (100) is configured to hold a voltage for controlling the current that the second transistor (Tr2) supplies to the light emitting element (20), and
the first transistor (Tr6) is connected to the storage capacitor (Cst).

3. The display device (DSP) of claim 2, **characterized by** further comprising:
data signal lines supplying a data signal (Data) to each of the plurality of pixels (PX); and
gate signal lines supplying a gate signal (Scan2) to each of the plurality of pixels (PX), **characterized in that**
the plurality of transistors (Tr1, Tr2, Tr3, Tr4, Tr5, Tr6, and Tr7) in the pixel circuit (100) include a third transistor (Tr1) that becomes an on state based on the gate signal (Scan2),
the data signal lines extend to be connected to the plurality of pixels (PX) arranged in the second direction (Y) and is arranged in the first direction (X), and
the gate signal lines extend to be connected to the plurality of pixels (PX) arranged in the first direction (X) and is arranged in the second direction (Y).

4. The display device (DSP) of claim 3, **characterized in that**
in each of the plurality of pixels (PX), the data signal (Data) is written to each of the plurality of pixels (PX) arranged in the first direction (X), and
the first transistor (Tr6) becomes the on state to write the data signal (Data) to the plurality of pixels (PX) arranged in the first direction (X).
